# EUROPEAN PATENT APPLICATION

(11) **EP 1 608 012 A1**
(43) Date of publication of application: **21.12.2005**
(21) Application number: 04716765.5
(22) Date of filing: 03.03.2004
(51) Int. Cl.: H01L 21/762

(54) **METHOD OF FORMING TRENCH ISOLATION STRUCTURE**

(30) Priority: 05.03.2003 JP 2003058365
(71) Applicant: AZ Electronic Materials USA Corp., Somerville, NJ 08876 (US)
(72) Inventor: ICHIYAMA, Masaaki C/o AZ Electronic Materials, Shizuoka 437-1412 (JP); NAGURA, Teruno C/o AZ Electronic Materials, Shizuoka 437-1412 (JP); ISHIKAWA, Tomonori C/o AZ Electronic Materials, 2-chome, Bunkyo-ku, Tokyo 113-0021 (JP); SAKURAI, Takaaki C/o AZ Electronic Materials, 2-chome, Bunkyo- ku, Tokyo 113-0021 (JP); SHIMIZU, Yasuo C/o AZ Electronic Materials, Ogasa-gun, Shizuoka 437-1412 (JP)
(74) Representative: Isenbruck, Günter
(86) International application number: PCT/JP2004/002638
(87) International publication number: WO 2004/079819

(57) **Abstract**

There is provided a method for trench isolation structure formation, which produces neither voids nor cracks within a groove. This method comprises the steps of: forming a groove on a surface of a silicon substrate; coating a polysilazane solution; prebaking the coating at a prebaking temperature regulated so that the temperature is raised in a temperature range of 50°C to 400°C over time; curing the coating at a temperature above the maximum prebaking temperature; and polishing and etching the film. The prebaking is carried out while raising the temperature either stepwise in two or more stages or in a monotonically increasing manner.

## Description

### BACKGOUND OF THE INVENTION

### Field of the Invention

The present invention relates to a method for the formation of a trench isolation structure in electronic devices. More particularly, the present invention relates to a method for the formation of a trench isolation structure, provided in an electronic device for insulation in the production of an electronic device such as a semiconductor device, using polysilazane.

### Background Art

In electronic devices such as semiconductor devices, in general, semiconductor elements, for example, transistors, resistors, and the like are disposed on a substrate and should be electrically isolated from each other. To this end, a region for isolating elements from each other should be provided between these elements. This region is called an isolation region. In general, this isolation region has hitherto been provided by selectively forming an insulating film on the surface of a semiconductor substrate.

On the other hand, in the field of electronic devices, in recent years, an increase in density and a higher level of integration have been advanced. The advance of an increase in density and a higher level of integration has made it difficult to form a fine isolation structure which can cope with the necessary level of integration. This has led to a demand for the development of a novel isolation structure which can meet the need. One of such structures is a trench isolation structure. In this structure, a fine groove is formed on the surface of the semiconductor substrate, and the inside of the groove is filled with an insulating material for electrically isolating elements formed on both sides of the groove from each other. This structure for element isolation can render the isolation region narrower than the conventional method and thus is an effective element isolation structure for realizing a high level of integration which has been demanded in recent years.

CVD and high density plasma CVD may be mentioned as methods for the formation of this trench isolation structure (see, for example, Japanese Patent No. 3178412, paragraphs 0005 to 0016). These methods, however, are disadvantageous in that, in some cases, voids are formed within the groove and the form of the groove formed in the substrate is changed. These structural defects are causative of a deterioration in physical strength and insulating properties of the substrate.

On the other hand, in order to improve burying properties of the trench groove, a method has also been studied in which silicon hydroxide is coated as a solution to form a coating which is then heat treated to convert silicon hydroxide to silicon dioxide (see, for example, Japanese Patent No. 3178412, paragraphs 0005 to 0016). In this method, however, in converting silicon hydroxide to silicon dioxide, volume shrinkage sometimes occurs, resulting in the occurrence of cracking.

In order to suppress such cracking, a method has also been studied in which polysilazane is used instead of silicon hydroxide (for example, Japanese Patent No. 3178412 and Japanese Patent Laid-Open No. 308090/2001). These methods aim to prevent cracking derived from volume shrinkage through the use of polysilazane of which the volume shrinkage in conversion to silicon dioxide is smaller. Studies conducted by the present inventors, however, revealed that, regarding these methods as well, there is a room for improvement.

### SUMMARY OF THE INVENTION

In view of the above problems of the prior art, an object of the present invention is to provide a method for the formation of a trench isolation structure that is free from the occurrence of structural defects, for example, causes only a very small volume shrinkage even in the case of very narrow trench width, and preferably does not cause any volume shrinkage at all.

According to the present invention, there is provided a first method for trench isolation structure formation, comprising:
a groove forming step of forming a trench isolation groove on a silicon substrate;
a coating step of coating a polysilazane solution, prepared by dissolving polysilazane in an organic solvent, onto said substrate to form a polysilazane coating;
a prebaking step of prebaking the coated substrate while regulating the temperature in the prebaking step so that the temperature is raised in a temperature range of 50°C to 400°C over time;
a curing step of treating the prebaked substrate in an inert gas or oxygen atmosphere having a water vapor concentration of not less than 1% at a temperature above the maximum prebaking temperature to 1000°C or below to convert the polysilazane coating to a silicon dioxide film;
a polishing step of selectively polishing said silicon dioxide film by CMP (chemical mechanical polishing); and
an etching step of selectively removing, by etching, the silicon dioxide film remaining unremoved after the polishing step.

Further, according to the present invention, there is provided a second method for trench isolation structure formation, comprising:
a groove forming step of forming a trench isolation groove on a silicon substrate;
a coating step of coating a polysilazane solution, prepared by dissolving polysilazane in an organic solvent, onto said substrate to form a polysilazane coating;
a prebaking step of prebaking the coated substrate while regulating the temperature in the prebaking step so that the temperature is raised in a temperature range of 50°C to 400°C over time;
a polishing step of selectively polishing said silicon dioxide film by CMP (chemical mechanical polishing);
an etching step of selectively removing, by etching, the silicon dioxide film remaining unremoved after the polishing step; and
a curing step of treating the prebaked substrate in an inert gas or oxygen atmosphere having a water vapor concentration of not less than 1% at a temperature above the maximum prebaking temperature to 1000°C or below to convert the polysilazane coating to a silicon dioxide film.

These methods for trench isolation structure formation according to the present invention can realize the production of a semiconductor substrate that is free from voids or cracks within the groove, that is, does not cause a deterioration in performance of semiconductor elements, and has excellent mechanical strength.

### DETAILED DESCRIPTION OF THE INVENTION

### First aspect of the invention

In the method according to one aspect of the present invention, treatments are carried out in the following order to form a trench isolation structure.
(A) Groove forming step
(B) Coating step
(C) Prebaking step
(D) Curing step
(E) Polishing step
(F) Etching step

Each step will be described in detail.

### (A)Groove forming step

In the method according to the present invention, a trench isolation groove is first formed in a silicon substrate. This groove may be formed by any method, and examples of methods usable herein include those described in Japanese Patent No. 3178412 or Japanese Patent Laid-Open No. 308090/2001. The method for groove formation will be specifically described.

A silicon dioxide film is first formed on the surface of a silicon substrate, for example, by thermal oxidation. The thickness of the silicon dioxide film is generally 5 to 30 nm.

If necessary, a silicon nitride film is formed on the formed silicon dioxide film, for example, by low pressure CVD. This silicon nitride film can function as a mask in a later etching step, or as a stop layer in a polishing step which will be described later. When the silicon nitride film is formed, the thickness of the silicon nitride film is generally 100 to 400 nm.

A photoresist is coated on the silicon dioxide film or the silicon nitride film thus formed. If necessary, the photoresist film is dried or cured, followed by exposure and development in a desired pattern to form a pattern. The exposure may be carried out by any desired method such as mask exposure or scanning exposure. The photoresist may be any desired one which is selected by taking into consideration, for example, resolution.

The silicon nitride film and the silicon dioxide film underlying the silicon nitride film are successively etched using the formed photoresist film as a mask. A desired pattern is formed in the silicon nitride film and the silicon dioxide film by this procedure.

The silicon substrate is dry etched using the patterned silicon nitride film and the silicon dioxide film as a mask to form a trench isolation groove.

The width of the trench isolation groove is determined by the pattern for photoresist film exposure. The trench isolation groove in the semiconductor element may vary depending upon the contemplated semiconductor element. The width is generally 0.02 to 10 µm, preferably 0.05 to 5 µm, and the depth is 200 to 1000 nm, preferably 300 to 700 nm. The method according to the present invention can realize uniform burying to a narrower and deeper part than the conventional method for trench isolation structure formation and thus is suitable for the formation of a narrower and deeper trench isolation structure.

If necessary, a polysilicon film may be further formed on the substrate surface with the groove formed therein, for example, by CVD. This polysilicon film functions (i) to relax stress produced between trenches by volume expansion in the conversion of polysilazane to silicon dioxide film in the curing step or the annealing step (which will be described later in detail), and (ii) to improve the adhesion between the polysilazane film and the substrate. The thickness of the polysilicon film is generally 1 to 50 nm, preferably 3 to 20 nm.

### (B)Coating step

Next, a polysilazane coating is formed on the silicon substrate with the groove formed on the surface thereof by the above groove forming step.

The polysilazane usable in the method according to the present invention is not particularly limited, and, for example, polysilazane described in Japanese Patent No. 3178412 or Japanese Patent Laid-Open No. 308090/2001 may be used. One example of a process usable for preparing a polysilazane solution will be described.

Dichlorosilane having a purity of not less than 99% is poured into anhydrous pyridine of which the temperature has been regulated in a range of -20 to 20°C with stirring.

Subsequently, ammonia having a purity of not less than 99% is poured into the solution which has been regulated to a temperature in a range of -20 to 20°C with stirring. Here in the reaction solution, a crude polysilazane and ammonium chloride as a by-product are produced.

Ammonium chloride produced by the reaction is removed by filtration.

The filtrate is heated to 30 to 150°C, and, while removing the remaining ammonia, the molecular weight of polysilazane is regulated to 1500 to 15000 in terms of weight average molecular weight.

The organic solvent is heated to 30 to 50°C, and the residual pyridine is removed by distillation under a reduced pressure of not more than 50 mmHg. Organic solvents usable herein include (i) aromatic compounds, for example, benzene, toluene, xylene, ethylbenzene, diethylbenzene, trimethylbenzene, triethylbenzene, and decahydronaphthalene, (ii) chain saturated hydrocarbons, for example, n-pentane, i-pentane, n-hexane, i-hexane, n-heptane, i-heptane, n-octane, i-octane, n-nonane, i-nonane, n-decane and i-decane, (iii) cyclic saturated hydrocarbons, for example, cyclohexane, ethylcyclohexane, methylcyclohexane and p-menthane, (iv) cyclic unsaturated hydrocarbons, for example, cyclohexene and dipentene (limonene), (v) ethers, for example, dipropylether, dibutylether and anisole, (vi) esters, for example, n-butyl acetate; i-butyl acetate, n-amyl acetate and i-amyl acetate, and (vii) ketones, for example, methyl i-butyl ketone.

Simultaneously with the removal of pyridine by the distillation under the reduced pressure, the organic solvent is removed to regulate the polysilazane concentration generally to 5 to 30% by weight.

The polysilazane solution thus obtained is subjected to circulation filtration through a filter with a filtration accuracy of not more than 0.1 µm to reduce the number of coarse particles with a particle diameter of not less than 0.2 µm to not more than 50 particles/cc.

The above method for preparing a polysilazane solution is merely one example of the preparation method, and the preparation method is not particularly limited to this only. For example, a method may also be adopted in which solid polysilazane is obtained and is generally dissolved or dispersed in the above proper solvent to give a concentration of 5 to 30% by weight. The concentration of the solution should be properly regulated by taking into consideration, for example, the thickness of the finally formed polysilazane coating film.

The polysilazane solution thus provided may be coated on the substrate by any method. Examples of coating methods include spin coating, curtain coating, dip coating and the like. Among them, spin coating is particularly preferred, for example, from the viewpoint of evenness of the coating face.

In order to simultaneously realize trench groove burying properties after coating of the polysilazane solution and the flatness of the polysilazane coating surface, the thickness of the polysilazane coating is preferably 0.8 time to twice the whole trench isolation groove formed in the groove forming step, that is, the total thickness of the silicon substrate, the silicon dioxide film and the silicon nitride film.

Although coating conditions vary depending upon the concentration of the polysilazane solution, the solvent, the coating method or the like, the coating conditions will be described by taking spin coating as an example.

In recent years, in many cases, elements are formed on a large substrate from the viewpoint of improving production yield. Spin coating comprising a combination of a plurality of stages is effective for the formation of a polysilazane coating uniformly on a silicon substrate having a size of 8 in or larger.

At the outset, a polysilazane solution is dropped on the center part of a silicon substrate, or on several places including the center part, such that a coating is evenly formed on the whole area of the substrate, generally in an amount of 0.5 to 20 cc per silicon substrate.

Next, the silicon substrate is spun at a relatively low speed for a short period of time, for example, at a spinning speed of 50 to 500 rpm for 0.5 to 10 sec to spread the dropped polysilazane solution over the whole area of the silicon substrate (prespinning).

The substrate is then spun at a relatively high speed, for example, at a spinning speed of 500 to 4500 rpm for 0.5 to 800 sec to provide a desired coating thickness (main spinning).

Further, in order to reduce rising of the polysilazane coating on the peripheral part of the silicon substrate and to remove the solvent in the polysilazane coating as much as possible, the substrate is spun at a speed of 500 rpm or more higher than the main spinning speed, for example, at a spinning speed of 1000 to 5000 rpm, for 5 to 300 sec (final spinning).

These coating conditions may be properly regulated by taking into consideration, for example, the size of the substrate used and the performance of the contemplated semiconductor element.

### (C)Prebaking step

The substrate coated with the polysilazane solution is subsequently transferred to the prebaking step. This step aims to completely remove the solvent contained in the polysilazane coating and to precure the polysilazane coating.

In the prior art technique, heating is carried out substantially at a constant temperature. In this case, in curing, the coating shrinks, resulting in the formation of a recess in the trench isolation groove part or the formation of voids within the groove.

One of the features of the present invention is that the temperature is regulated in the prebaking step, and prebaking is carried out while raising the temperature over time. In this case, the temperature in the prebaking step is generally 50°C to 400°C, preferably 100 to 300°C. The time necessary for the prebaking step is generally 10 sec to 30 min, preferably 30 sec to 10 min.

Methods usable for raising the temperature in the prebaking step over time include a method in which the temperature of an atmosphere in which the substrate is placed is raised in incremental stages or stepwise, or a method in which the temperature is raised monotonically. In this case, the highest brebaking temperature in the prebaking step is generally above the boiling point of the solvent used in the polysilazane solution from the viewpoint of removing the solvent from the coating.

According to the method in which the temperature in the prebaking step is raised in incremental stages, holding the substrate at a particular constant temperature for a given period of time followed by holding of the temperature of the substrate at a higher constant temperature for a given period of time, for example, holding the substrate at temperature T1 for several min followed by holding of the substrate at temperature T2, a temperature above temperature T1, for several min, is repeated. The difference in temperature between the incremental stages is generally 30 to 150°C. The time for which the substrate is held at the constant temperature is generally 10 sec to 3 min for each temperature. Prebaking under the above conditions can significantly develop the effect of the present invention.

For example, when prebaking is carried out in two temperature incremental stages, the first-stage prebaking temperature is preferably in the range of (1/4) A to (3/4) A (°C) wherein A (°C) represents the second-stage prebaking temperature (the highest prebaking temperature).

Further, for example, when prebaking is carried out in three temperature incremental stages, the first-stage prebaking temperature is preferably in the range of (1/4) A to (5/8) A (°C), and the second-stage prebaking temperature is preferably in the range of (5/8) A to (7/8) A (°C), wherein A (°C) represents the third-stage prebaking temperature (the highest prebaking temperature).

For example, when a solvent having a boiling point of about 150°C such as xylene is used in the polysilazane solution and 200°C is selected as the highest prebaking temperature, (a) in the case of prebaking in two temperature incremental stages, the first-stage prebaking temperature is preferably in the range of 50 to 150°C, and (b) in the case of prebaking in three temperature incremental stages, the first-stage prebaking temperature and the second-stage prebaking temperature are preferably in the range of 50 to 125°C and 125 to 175°C, respectively.

That is, also in the method utilizing temperature incremental stages, temperature setting for the plurality of incremental stages is carried out so that, regarding the whole prebaking step, the temperature reaches the target temperature with moderate rise in temperature.

In the case of the method in which the temperature is raised monotonically, the temperature value should be at least 0°C above the temperature in an earlier point of time. In this case, the difference in temperature between a certain point of time and an earlier point of time may be 0 (zero) but should not be minus. In other words, when the prebaking temperature is plotted against the time, the slope of the temperature curve should not be negative. Here the substrate temperature is generally raised at a temperature rise rate of 0 to 500°C/min, preferably 10 to 300°C/min. A higher temperature rise rate leads to more significant shortening of the process time. From the viewpoints of removing the solvent present within the groove structure and realizing satisfactory polymerization of polysilazane, however, the adoption of a low temperature rise rate is preferred.

In the present invention, the expression "regulated so that the temperature in the prebaking step is raised over time" excludes the case where, for example, a low-temperature substrate is transferred to high-temperature conditions to rapidly raise the substrate temperature to render the temperature identical to the temperature of the atmosphere followed by prebaking of the substrate while maintaining the temperature. In this case, although the substrate temperature is raised over time, the temperature rise is not regulated and, in this case, the effect of the present invention could not be attained.

In the prebaking step, the temperature regulation is carried out from the viewpoints of preventing rapid temperature rise of the coating in the prebaking step and raising the temperature at a lower temperature rise rate than the case of perbaking by the conventional one-stage heating. The reason why, for example, voids within the groove are reduced by the method according to the present invention has not been fully elucidated yet. However, the reason for this is believed to reside in that, upon rapid temperature rise of the substrate, before the solvent is fully removed from the inside of the trench isolation groove, disadvantageously, the surface is excessively cured and, consequently, vapor of the solvent stays within the groove. According to the present invention, this problem is solved by regulating the temperature in the prebaking step.

### (D) Curing step

After prebaking, the polysilazane coating is converted to a silicon dioxide film and to cure the film. To this end, the polysilazane coating is heated. Heating of only the polysilazane coating suffices for curing of the polysilazane coating. In general, however, the whole substrate is introduced into a curing oven or the like for heating.

In the method according to the present invention, the substrate which has been brought to a high temperature in the prebaking step, before the temperature falls below 50°C, that is, the substrate at a temperature of 50°C or above and at a temperature at or below the highest temperature in the prebaking, is applied to the curing step. When the substrate is applied to the curing step before the temperature of the substrate falls, energy and time necessary for again raising the temperature can be saved.

Curing is generally carried out using a curing oven or a hot plate in an inert gas or oxygen atmosphere having a water vapor concentration of not less than 1%. Water vapor is indispensable for fully converting polysilazane to silicon dioxide, and the concentration of the water vapor is generally not less than 1%, preferably not less than 5%. When the inert gas is used as the atmosphere gas, for example, nitrogen, argon, or helium is used.

Temperature conditions for curing vary depending upon the kind of polysilazane used and a combination of steps (which will be described later). In the method according to the present invention, curing is carried out in one stage at a temperature at or above the highest prebaking temperature to 1000°C or below, preferably at a temperature at or above the highest prebaking temperature to 800°C or below. The highest prebaking temperature refers to the highest temperature in the prebaking step. In the present invention, since the temperature in the prebaking step is raised over time, the highest prebaking temperature is equal to the final temperature in the prebaking step. In this case, the temperature rise rate until the temperature reaches the target temperature is generally 1 to 100°C/min, and the curing time after the temperature reaches the target temperature is generally one min to 10 hr, preferably 15 min to 3 hr. If necessary, the curing temperature or the composition of the curing atmosphere may be varied stepwise.

### (E)Polishing step

After the polysilazane coating is cured, the cured silicon dioxide film in its unnecessary parts are removed. To this end, at the outset, in the polishing step, the polysilazane coating on the substrate surface is removed. This step is the polishing step.

The polishing is carried out by chemical mechanical polishing (hereinafter referred to as "CMP"). The polishing by CMP may be carried out using conventional polishing agent and polishing apparatus. Specifically, for example, a dispersion of an abrasive material such as silica, alumina, or ceria and optionally other additives in water may be used as the polishing agent. The polishing apparatus may be a commercially available conventional CMP apparatus.

### (F) Etching step

In the polishing step, the polysilazane-derived silicon dioxide film on the substrate surface is almost removed. However, in order to remove the residual silicon dioxide film, etching treatment is further carried out. The etching treatment is generally carried out with an etching liquid. The etching liquid is not particularly limited so far as it can remove the silicon dioxide film. In general, however, an aqueous hydrofluoric acid solution containing ammonium fluoride is used. The concentration of ammonium fluoride in this aqueous solution is preferably not less than 5%, more preferably not less than 30%.

When the silicon nitride film is formed on the silicon dioxide film adjacent directly to the substrate surface, subsequent to the etching step (F), the silicon nitride film is also removed by etching. In general, this etching treatment is also carried out with an etching liquid. The etching liquid is not particularly limited so far as it can remove the silicon nitride film. In general, however, an aqueous phosphoric acid solution having a concentration of not less than 70% is used, and the temperature is generally regulated to about 80°C.

In the first embodiment according to the present invention, the contemplated trench isolation structure can be formed by conducting the treatments in the above order. If necessary, additional steps may be used in combination with the above steps.

For example, the steps from (B) coating step to (D) curing step are repeated twice or more. Specifically, after (D) curing step, the second (B) coating step and the second (C) prebaking step, and (D) curing step may be carried out. When such treatments are carried out, the thickness of the polysilazane coating formed in the first coating step is preferably small. When the thickness of the silicon dioxide film derived from the polysilazane coating formed in a series of (B) coating step to (D) curing step is small, the amount of the residual solvent in the deep part within the groove can be reduced. Therefore, the voids produced within the groove can further be reduced.

Further, the steps from (B) coating step to (D) curing step for silicon dioxide film formation may be combined with CVD, preferably high-density plasma CVD. Specifically, in the steps from (B) coating step to (D) curing step, a silicon dioxide film having a smaller thickness than the desired thickness is formed, and an additional silicon dioxide film is then deposited by CVD. When the trench isolation structure is formed only by CVD, as described above, voids are likely to be formed within the groove. When silicon dioxide is previously buried in the deep part of the groove structure by the method according to the present invention, however, the production of voids within the groove derived from CVD can be prevented.

In order to further fully cure the formed silicon dioxide film, treatment for further heating the silicon dioxide film in an inert gas or oxygen atmosphere having a water vapor concentration of not less than 1% to recure the silicon dioxide film may also be carried out between (E) polishing step and (F) etching step. Specifically, when the film is fully cured after polishing without full curing in (D) curing step, the degree of freedom of polishing conditions can be increased. Further, shortening of the distance from the deepest part of the groove to the surface followed by full curing can facilitate the removal of the residual organic solvent present in the deep part of the groove. Heating conditions for the recuring may vary depending upon purposes and the like. In general, however, the heating is carried out at 400 to 1000°C, preferably 600 to 800°C. At that time, the heating time is generally 10 sec to 3 hr, preferably one min to one hr.

Further, between (E) polishing step and (F) etching step, the formed silicon dioxide film may be annealed to densify the silicon dioxide film. The densification is generally carried out at a temperature of 400 to 1200°C, preferably 600 to 1000°C. At that time, the heating time is generally 10 sec to 3 hr, preferably one min to one hr. Unlike the above recuring step, the presence of water vapor in the atmosphere is not necessary.

### Second aspect of the invention

The present invention includes the second aspect of the invention which is the same as the first aspect of the invention, except that the order of steps are changed. In the second aspect of the invention, a trench isolation structure is formed by carrying out the steps in the following order.
(A)Groove forming step
(B)Coating step
(C)Prebaking step
(E) Polishing step
(F) Etching step
(D) Curing step
Each step may be carried out under the above-described conditions.

Step (F) is carried out for removing the polysilazane-derived film (not fully converted to silicon dioxide) that is a part which is excessive for trench isolation structure formation.

In the prior art technique, it is considered that the reason why a recess part is formed on the surface of a small-width trench groove part is that, in shrinkage of the polysilazane, buried in the trench groove part, during the curing step, a narrower width causes larger internal stress, resulting in reduced density. In the method according to the second aspect of the present invention, the formation of the recess part on the substrate surface can be prevented, probably because, before the polysilazane buried in the trench groove part is shrunk in the curing step, the polysilazane is previously etched to a necessary level and, after the formation of the trench isolation structure, the polysilazane is cured and converted to silicon dioxide.

### EXAMPLES

### Preparation of polysilazane solutions

### (A) Polysilazane solution A

Polysilazane solution A was prepared by the following method.
(1) 48 g of dichlorosilane having a purity of not less than 99% is poured into 500 g of anhydrous pyridine of 0°C with stirring.
(2) Subsequently, 27 g of ammonia having a purity of 99.9% is poured with stirring while maintaining the liquid temperature at 0°C over a period of 3 hr.
(3) After the completion of pouring of ammonia, the resultant ammonium chloride is removed by filtration.
(4) The filtrate from which ammonium chloride had been removed was heated to 50°C to remove the residual ammonia. A polysilazane having a weight average molecular weight of 2000 was formed in the filtrate.
(5) Xylene was mixed into the filtrate from which ammonia had been removed. The mixture was distilled under a reduced pressure of 20 mmHg at 50°C to remove pyridine and to bring the polymer concentration to 20% by weight.
(6) The polymer solution thus obtained was purified by circulation filtration through a filter with a filtration accuracy of 0.1 µm. The number of particles having a size of 0.2 µm or more contained in the polymer solution was measured with a particle counter KS40-BF manufactured by RION Co., Ltd. and was found to be three particles per cc.

### (B) Polysilazane solution B

In step (5), the amount of pyridine removed was regulated to prepare polysilazane solution B having a polymer concentration of 10% by weight. For polysilazane solution B as well, the number of particles was measured in the same manner as in polysilazane solution A and was found to be three particles per cc.

### (C) Polysilazane solution C

Polysilazane solution C was prepared in the same manner as in Example 1 of Japanese Patent No. 1474685 as follows.
(1) 150 ml of deaerated dry pyridine was cooled in ice, and 16.1 g of dichlorosilane was added to the cooled pyridine over a period of 50 min.
(2) The reaction solution was cooled in ice, and 10.9 g of ammonia was blown into the reaction solution with vigorous stirring over a period of one hr.
(3) A solid product was removed from the reaction solution by centrifugation and filtration, and the solvent was removed from the filtrate under the reduced pressure to give a polysilazane as a glassy solid.
(4) The polysilazane thus obtained was dissolved in xylene to give a 20 wt% solution which was then purified by circulation filtration through a filter with a filtration accuracy of 0.1 µm.

### Formation of trench isolation groove

A trench isolation groove was formed in a silicon substrate according to "second embodiment" of Japanese Patent No. 3178412 as follows.
(1) A silicon dioxide film was formed by thermal oxidation on the surface of a silicon substrate, and a silicon nitride film was formed thereon by CVD.
(2) A photoresist was coated onto the formed silicon nitride film, followed by exposure and development by photolithography for patternization. In this case, the patternization was carried out so that the finally obtained patterns were line grooves of 1 µm, 0.5 µm, 0.2 µm, 0.1 µm, and 0.05 µm.
(3) The patterned photoresist film was used as a mask to successively dry etch the silicon nitride film and the silicon dioxide film. The dry etching resulted in the formation of holes extended through the silicon nitride film and the silicon dioxide film to cause linear exposure of the silicon substrate.
(4) The photoresist was removed to expose the silicon nitride film. This silicon nitride film was used as a mask to etch the silicon substrate and thus to form a groove structure in the silicon substrate. Further, a silicon dioxide film was also formed within the groove by thermal oxidation. Furthermore, a silicon nitride film was also formed within the groove by CVD for the formation of a trench isolation groove. This silicon nitride film functions to suppress the oxidation of silicon in curing polysilazane in a later step.

### Example 1

A trench isolation structure was formed by the following method in the silicon substrate with a trench isolation groove formed by the above method.
(1) Polysilazane solution A was spin coated on the silicon substrate under coating conditions of rotation speed 1000 rpm and rotation time 30 sec. When coating was carried out under the same conditions on a bare silicon substrate, the coating thickness was 600 nm.
(2) The coated substrate was prebaked by heating at 100°C, 150°C and 200°C sequentially each for 2 min.
(3) The prebaked substrate was introduced into a curing oven under a pure oxygen atmosphere while maintaining the temperature at 200°C, where the prebaked substrate was heated under an oxygen atmosphere having a water vapor concentration of 70% to 800°C at a temperature rise rate of 10°C/min and was further heated at that temperature for 30 min to cure the coating.
   For a film formed by coating a polysilazane solution onto bare silicon and curing the coating under the same conditions, the chemical structure was analyzed by FTIR. As a result, only absorption of Si-O bond attributed to wavenumber 1080 cm⁻¹ was observed, and neither absorption of N-H bond attributed to wavenumber 3380 cm⁻¹ nor absorption of S-H bond attributed to 2200 cm⁻¹ was observed, indicating that, under the above conditions, the raw material polysilazane was fully converted to silicon dioxide.
(4) The silicon dioxide film on the surface of the silicon substrate was polished by CMP until the silicon nitride film was exposed.
(5) The silicon nitride film exposed on the surface was removed by etching with an aqueous phosphoric acid solution of 80°C.
(6) The silicon dioxide film was etched with an aqueous solution containing 30% by weight of ammonium fluoride and 1% of hydrofluoric acid to a position near the silicon substrate to form a trench isolation structure.

### Example 2

The procedure of Example 1 was repeated, except that the polysilazane solution was changed to polysilazane solution B, coating of the polysilazane solution and curing were divided in three times, and steps (1) to (3) were repeated three times.

### Example 3

The procedure of Example 1 was repeated, except that the polysilazane solution was changed to polysilazane solution B and, after step (3), a 300 nm-thick silicon dioxide film was formed by HDP-CVD.

### Example 4

A trench isolation structure was formed in the same manner as in Example 1, except that a 10 nm-thick polysilicon film was formed on the silicon substrate by CVD followed by coating of the polysilazane solution.

### Example 5

A trench isolation structure was formed in the same manner as in Example 1, except that, after step (4) in Example 1, the step of bringing again the temperature to 200°C, introducing the assembly into a curing oven under a pure oxygen atmosphere, and heating the assembly under an oxygen atmosphere having a water vapor concentration of 70% to 800°C at a temperature rise rate of 10°C/min.

### Example 6

A trench isolation structure was formed in the same manner, as in Example 1, except that, after step (5) in Example 1, the substrate was annealed under a nitrogen atmosphere at 1000°C to densify silicon dioxide.

### Example 7

A trench isolation structure was formed in the same manner as in Example 1, except that, after the steps up to the prebaking step as step (2) in Example 1 were carried out, the step of polishing by CMP and etching of the polysilazane-derived silicon dioxide film to a position near the substrate as step (4) were carried out before step (3). Here an aqueous solution containing 30% by weight of ammonium fluoride and 1% of hydrofluoric acid was used for etching before step (3).

### Comparative Example 1

A trench isolation structure was formed according to "second embodiment" described in Japanese Patent No. 3178412 as follows.
(1) Polysilazane solution C was coated onto a silicon substrate by spin coating.
(2) The coated silicon substrate was prebaked by allowing the coated silicon substrate to stand in an inert atmosphere at 200°C for 3 min.
(3) The prebaked coated silicon substrate was introduced in an electric oven, was heated in a water vapor atmosphere at 400°C for 60 min. The temperature was then raised to 900°C, and the substrate was allowed to stand for 60 min.
(4) The silicon dioxide film on the surface of the silicon substrate was polished by CMP until the silicon nitride film was exposed.
(5) The silicon nitride film exposed on the surface was removed by etching with an aqueous phosphoric acid solution of 80°C.
(6) The silicon dioxide film was etched with an aqueous solution containing 30% by weight of ammonium fluoride and 1% of hydrofluoric acid to a position near the silicon substrate to form a trench isolation structure.

### Comparative Example 2

A trench isolation structure was formed according to "second embodiment" described in Japanese Patent No. 3178412 as follows.
(1) Polysilazane solution A was coated onto a silicon substrate by spin coating.
(2) The coated silicon substrate was prebaked by allowing the coated silicon substrate to stand in an inert atmosphere at 300°C for 2 min.
(3) The prebaked substrate is introduced into an electric oven at 200°C while introducing pure oxygen as an atmosphere gas, where the substrate is heated in an oxygen atmosphere containing a water vapor concentration of 70% to a temperature of 800°C at a temperature rise rate of 10°C/min to cure the coating.
(4) The silicon dioxide film on the surface of the silicon substrate was polished by CMP until the silicon nitride film was exposed.
(5) The silicon nitride film exposed on the surface was removed by etching with an aqueous phosphoric acid solution of 80°C.
(6) The silicon dioxide film was etched with an aqueous solution containing 30% by weight of ammonium fluoride and 1% of hydrofluoric acid to a position near the silicon substrate to form a trench isolation structure.

Under the same conditions as in Examples 2 to 7 and Comparative Examples 1 and 2, a polysilazane solution was coated onto bare silicon to form a coating, and the coating was cured to form a film of which the chemical structure was analyzed by FTIR. As a result, it was found that, for all the cases, the raw material polysilazane was fully converted to silicon dioxide.

### Evaluation

For the silicon substrates in respective Examples, the section of the trench was observed under SEM to evaluate the following items.
(1) For the trench isolation structures respectively with widths of 0.5 µm, 0.2 µm, 0.1 µm and 0.05 µm, how much lower the surface of the filled material in the trench groove part is relative to the upper end of the trench isolation structure with a width of 1 µm.
(2) The presence or absence of nonuniform parts such as voids in the trench isolation structure with a width of 0.05 µm.

The results were as shown in Table 1.

**Table 1**

| | Relative height from upper end of trench with width 1.0 µm | | | | Void |
|---|---|---|---|---|---|
| Trench width | 0.5 µm | 0.2 µm | 0.1 µm | 0.05 µm | 0.05 µm |
| Example 1 | 0.00 µm | -0.03 µm | -0.05 µm | -0.08 µm | None |
| Example 2 | 0.00 µm | 0.00 µm | -0.02 µm | -0.04 µm | None |
| Example 3 | -0.01 µm | -0.02 µm | -0.02 µm | -0.04 µm | None |
| Example 4 | -0.01 µm | -0.01 µm | -0.01 µm | -0.02 µm | None |
| Example 5 | -0.01 µm | -0.01 µm | -0.03 µm | -0.04 µm | None |
| Example 6 | 0.00 µm | -0.01 µm | -0.01 µm | -0.01 µm | None |
| Example 7 | -0.01 µm | -0.01 µm | -0.03 µm | -0.05 µm | None |
| Comp. Ex. 1 | -0.03 µm | -0.09 µm | -0.24 µm | -0.41 µm | Present at lower end |
| Comp. Ex. 2 | -0.05 µm | -0.08 µm | -0.18 µm | -0.22 µm | None |

In the table, minus indicates that the upper end of the trench part is lower than the upper end of trench with width 1.0 µm.

As is apparent from the above results, the trench isolation structures formed by the method according to the present invention can provide substrates that are free from structural defects such as voids, have uniform trench upper end height, and have excellent planarity. On the other hand, for the trench isolation structures formed by the conventional method, it is apparent that a narrower trench width provides a lower relative height of the filled material within the trench groove and causes a recess from the plane of the substrate and further causes the occurrence of voids.

## Claims

1. A method for trench isolation structure formation, comprising:
a groove forming step of forming a trench isolation groove on a silicon substrate;
a coating step of coating a polysilazane solution, prepared by dissolving polysilazane in an organic solvent, onto said substrate to form a polysilazane coating;
a prebaking step of prebaking the coated substrate while regulating the temperature in the prebaking step so that the temperature is raised in a temperature range of 50°C to 400°C over time;
a curing step of treating the prebaked substrate in an inert gas or oxygen atmosphere having a water vapor concentration of not less than 1% at a temperature above the maximum prebaking temperature to 1000°C or below to convert the polysilazane coating to a silicon dioxide film;
a polishing step of selectively polishing said silicon dioxide film by CMP (chemical mechanical polishing); and
an etching step of selectively removing, by etching, the silicon dioxide film remaining unremoved after the polishing step.

2. The method for trench isolation structure formation according to claim 1, wherein said polishing is carried out after repeating the steps from the coating step to the curing step twice or more.

3. The method for trench isolation structure formation according to claim 1 or 2, wherein, after said curing steps, the silicon dioxide film is formed by a high-density plasma CVD process followed by said polishing.

4. The method for trench isolation structure formation according to any one of claims 1 to 3, wherein, before the coating step, a polysilicon film is formed on the surface of the silicon substrate by a CVD process.

5. The method for trench isolation structure formation according to any one of claims 1 to 4, which further comprises, between said polishing step and said etching step, a recuring step of further heating the assembly in an inert gas or oxygen atmosphere having a water vapor concentration of not less than 1% to cure said silicon dioxide film.

6. The method for trench isolation structure formation according to any one of claims 1 to 5, which further comprises, after said polishing step, a densification step of annealing said silicon dioxide film at a temperature of 400°C to 1200°C or below to densify said silicon dioxide film.

7. A method for trench isolation structure formation, comprising:
a groove forming step of forming a trench isolation groove on a silicon substrate;
a coating step of coating a polysilazane solution, prepared by dissolving polysilazane in an organic solvent, onto said substrate to form a polysilazane coating;
a prebaking step of prebaking the coated substrate while regulating the temperature in the prebaking step so that the temperature is raised in a temperature range of 50°C to 400°C over time;
a polishing step of selectively polishing said silicon dioxide film by CMP (chemical mechanical polishing);
an etching step of selectively removing, by etching, the silicon dioxide film remaining unremoved after the polishing step; and
a curing step of treating the prebaked substrate in an inert gas or oxygen atmosphere having a water vapor concentration of not less than 1% at a temperature above the maximum prebaking temperature to 1000°C or below to convert the polysilazane coating to a silicon dioxide film.
